# EUROPEAN PATENT SPECIFICATION

(11) **EP 0 577 433 B1**
(45) Date of publication and mention of the grant of the patent: **15.10.1997**
(21) Application number: 93305215.1
(22) Date of filing: 02.07.1993
(51) Int. Cl.: H05K 7/14, H05K 7/18

(54) **Racks for electronic equipment**
Gestelle für elektronische Ausrüstung
Rack pour équipement électronique

(30) Priority: 03.07.1992 GB 9214106
(43) Date of publication of application: 05.01.1994
(73) Proprietor: VERO ELECTRONICS LIMITED, Eastleigh Hants S05 3ZR (GB)
(72) Inventor: Barlow, Barry, Winchester, Hampshire SO21 3EQ (GB)
(74) Representative: Williams, Janice

(56) References cited:
- EP-A- 0 420 491
- DE-A- 3 038 783

## Description

This invention relates to racks for electronic equipment and more particularly to modular racks suitable for mounting a plurality of card-frames (each designed to accommodate a number of standard sized circuit cards and interconnect them) in a vertical array. The racks in accordance with the invention are especially (but not exclusively) suitable for use with telecommunications equipment, such as telephone switching equipment, in which the number of external connections per circuit board tends to be high.

Module dimensions for such racks are predetermined by Standards Authorities, such as the European Telecommunications Standards Institute (ETSI), which specifies a module with a width of 600mm and a depth of 300mm. Of the available 600mm of width, a central 500mm is reserved for the card-frames, leaving 50mm at each side to accommodate structural members. Cables running in a generally vertical direction from frame to frame and/or to and from cable ducts (usually placed at the bottom or at the top of the racks) must be located behind the card frames or with the structural members in the 50mm spaces at the sides of the modules. Current practice is to locate cables on the insides of the structural members and/or inside the back of the module; this makes initial cabling relatively easy if it can be completed before any card-frames are installed, but makes it extremely difficult to alter or add to the wiring after the card-frames are in position; either the card-frames must be withdrawn (necessitating or risking interruptions to circuits not involved in the work in hand) or cables must be threaded through narrow gaps (not big enough to pass a hand through) in relatively inaccessible positions.

EP-A-0 420 491 discloses an adjustable rack for electronic equipment in which two vertical frame members form the sides of the rack and support equipment therebetween. The frame members are generally U-shaped in cross-section and are open outwardly to the sides of the rack to receive cables, and the front arms of the U-shaped frame members are of smaller width than the rear arms to allow access to the cable spaces from the front when two racks are placed side by side.

In accordance with the invention, there is provided a rack for electronic equipment based on modules of predetermined size, the rack comprising a pair of vertical structural members positioned on respective sides of the rack to receive and support card-frames of predetermined dimensions in a vertical array between them and to support cables to be connected to electronic equipment to be mounted in one or more of the said card-frames, wherein each structural member comprises a vertically extending central portion, a rear flanged portion extending outwardly from the central portion to the respective side of the rack and then forwardly towards the front of the rack, and a front flanged portion extending outwardly from the central portion to the side of the rack, the rear flanged portion extending outwardly further than the front flanged portion, and wherein the said structural members define at respective sides of the rack vertically extending cabling spaces which are open and free of fixed obstructions over at least a major part, or major parts, of the height of the cabling spaces
(a) outwardly to respective sides of the rack over at least a major part of the depth from front to back of the rack;
(b) towards the front of the rack adjacent to its side; and
(c) inwardly towards the card-frame mounting space over at least a major part, or major parts, of the height of the rack.

Embodiments of the present invention provide a modular card-frame rack that provides facile cabling access from the front of the equipment even when the card-frames and boards are in position and in service, without necessitating departure from the standard module dimensions. In some preferred forms of the invention, threading of cables through openings can be wholly eliminated.

The openings to the sides of the module allow two such racks to be mounted in a conventional side-to-side position, without mounting side-panels or partitions between them, so that the adjoining cabling spaces of the two racks come together to create a common cabling space of double width; in the case of a rack to ETSI dimensions this means a common cabling space wide enough to get a hand in, and in every case it means that cables can if required be positioned along the module boundary (e.g., in an ETSI rack, the width of the cabling space will be around 40mm and will accept two layers of cables all 15mm in diameter leaving a waste space of 10mm; by bringing two such cabling spaces together, not four but five layers of these cables can be accommodated.

The opening to the front of the module allows cables to be inserted (and removed, if required) from the front of the apparatus, whether or not card-frames and equipment are in place or in service.

Preferably these openings to the side and the front are free of all fixed obstructions from top to bottom of the rack so that cables can be installed (or removed) without any threading through openings. For "heavy duty" racks that may be subject to vibration, welded or otherwise permanently fixed stiffeners can be tolerated provided they are well spaced to make it easy to thread cables behind them, but wherever possible removable stiffeners (such as bolted ones) are preferred.

Each of the cabling spaces is also open inwardly towards the card-frame mounting space at least over major parts of its height. The primary function of such opening towards the inside is to provide access for the ends of cables (and/or for conductors of stripped-back cable ends, as required) to enter the card-frames for making connections thereto. For neatest results, they should enter the card-frames through a forward part of the appropriate side thereof, either through an opening in the side or over the top edge (or under the bottom edge) of the side. If preferred, however, cable or conductor ends may be brought forward to enter the card-frames through, over or under the front face thereof. Opening towards the inside also has a secondary function of improving access to the rear part of the cabling space when card-frames are not present. Since neither of these functions demands vertical continuity, the advantage of the opening being continuous in a vertical direction is small and in some cases a spaced series of openings related to the vertical spacing of the card-frames might be preferred.

Preferably tabs or other formations are provided on the sides of the structural members that face the cabling spaces in order to provide anchorages for ties or other securing means for cables.

Conventional card-frames are mounted in their racks by flanges projecting outwardly from their front vertical edges to be fixed by screws or the like to the structural members of conventional racks. For use with racks of the present invention in which the cabling spaces are open inwardly over a major part or major parts of its height, it is preferable to relocate the flanges away from the front face of the card-frames to engage the main front face of the structural member. However, such racks may in any case be made fully compatible with standard card-frames by use of spacers mounted either on the front of the structural members (in which case they are preferably removable) or on the rear of the flanges. In either case, the spacers may be provided with tabs or other formations to provide additional anchorages for ties or other cable fixing means.

Removable trim members may be used to enclose the front of each cabling space to improve appearance: such trim members may be provided with brush edges, flexible edges, openings or knock-outs, as preferred, to permit passage of cables around the front edges of card-frames, if required.

Racks in accordance with the invention may also be fitted with doors, back panels, side panels (when standing alone or at the end of a row) or other accessories, and may be secured back-to-back with one another or with standard racks when required.

The invention will be further described, by way of example, with reference to the accompanying drawings in which:
- Figure 1: is an isometric view of a rack embodying the invention;
- Figure 2: is a plan view of a slightly modified form of rack embodying the invention;
- Figure 3: is a view showing part of the rack of Figure 2 in greater detail;
- Figure 4: is a plan view showing adjacent portions of two of the racks of Figures 2 and 3; and
- Figure 5: is a diagrammatic front view of the rack of Figures 2 and 3 showing typical cable runs for a telecommunications application.

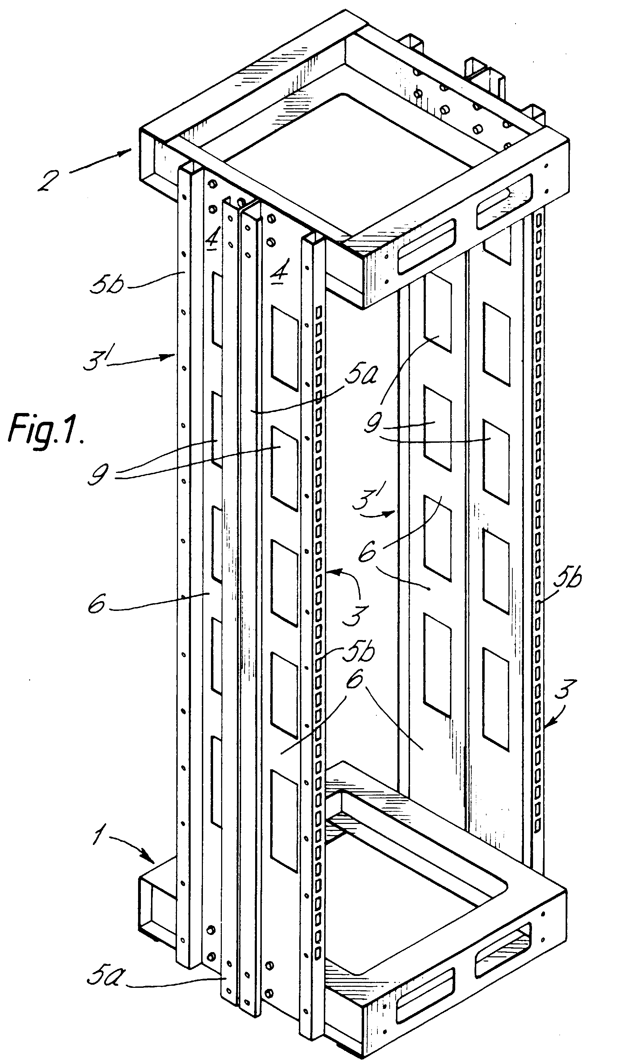

Referring to the accompanying drawings, Figure 1 shows a double rack which comprises a base 1 and top unit 2 that are connected by means of structural members 3,3'. Each structural member 3,3' is formed from a steel strip and has a rear flanged portion 5a and a front flanged portion 5b which, together with the central portion 6 defines a cabling space 4 that is opened outwardly in relation to the rack. The rear flanged portion 5a is of greater height than the front flanged portion 5b so that the cabling space 4 is also open to the front as explained below. A number of apertures 9 are provided in the structural members 3 for allowing cables to pass between the cabling space 4 and the card-frames located between the structural member 3,3'. Cable supports (not shown) may be fitted on the structural members 3,3' in the region of the apertures if desired in order to organize the cables and keep them tidy.

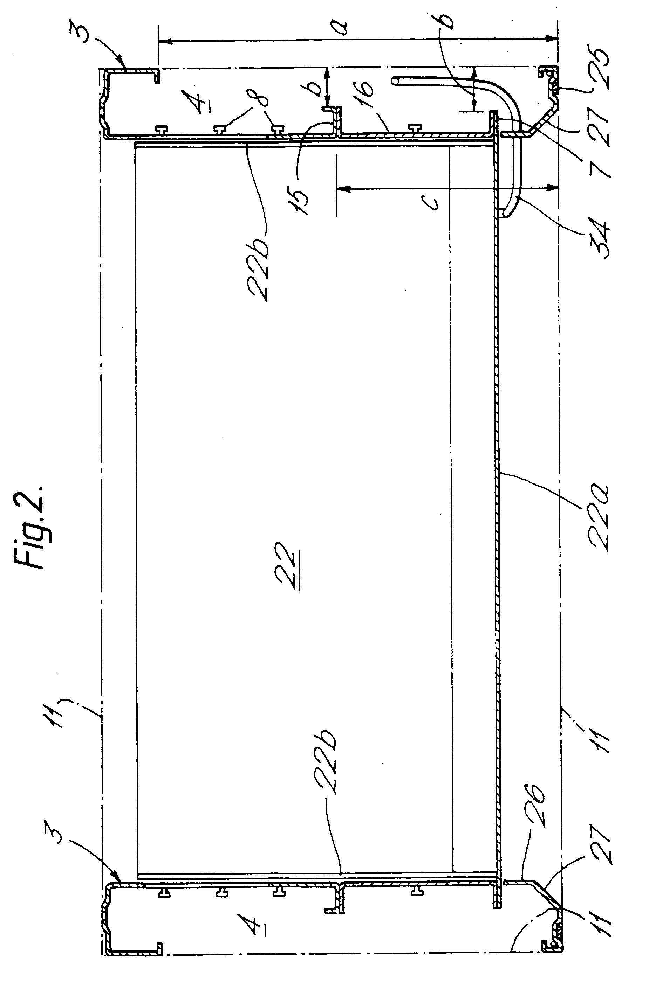

Figures 2 to 5 show a rack that corresponds to that shown in Figure 1 with the slight modification of the design of the front flanged portion 5b of the structural members 3 and that only two structural members 3 are employed.

In Figure 2, the chain-line 11 shows the 600 by 300mm ETSI module within which the rack must be contained, and the outline 22 is that of the standard card-frames, to be supported each card-frame having a front plate 22a and a pair of end plates 22b. Between the card-frames and the ends of the modules are a pair of structural members 3,3 which are shaped, in accordance with the invention, to form respective cabling spaces 4,4 not between the structural members and the card-frames but between the structural members and the ends of the modules. The cabling space 4 is, in this example, open outwardly to the side of the module over the major part *a* of its depth, forwardly over the major part *b* of its width, and inwardly over the front part *c* of its depth. For mounting card-frames to the structural members, either their mounting flanges may be relocated as seen at 15, or spaces 16 may be used to secure standard flanges 7 at the fronts of the card-frames.

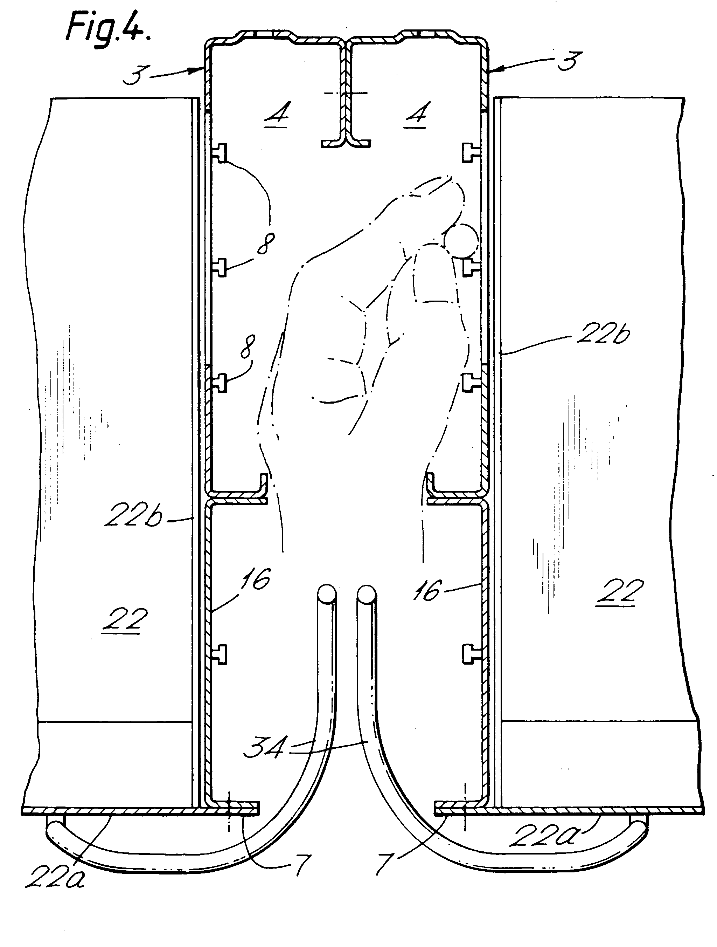

As seen in Figure 4, when two such racks are mounted side by side, the adjoining cabling spaces come together to form a combined space, fully open to the front of the rack even when the card-frames are in position, big enough and accessible enough for cables to be positioned by inserting a hand, at least until the space becomes substantially occupied by cables.

Tabs 8, struck up from the sheet metal blank from which the structural member 3 is formed, forming anchorages for cable ties, and apertures 9 for passing cables in a conventional manner into the rear part of the card-frame 2 if the design of the equipment and circumstances of the installation make it convenient to do so. Apertures 20,21 may also be provided for mounting the rack to another similar rack or to a wall 35 respectively behind and to the side of this rack.

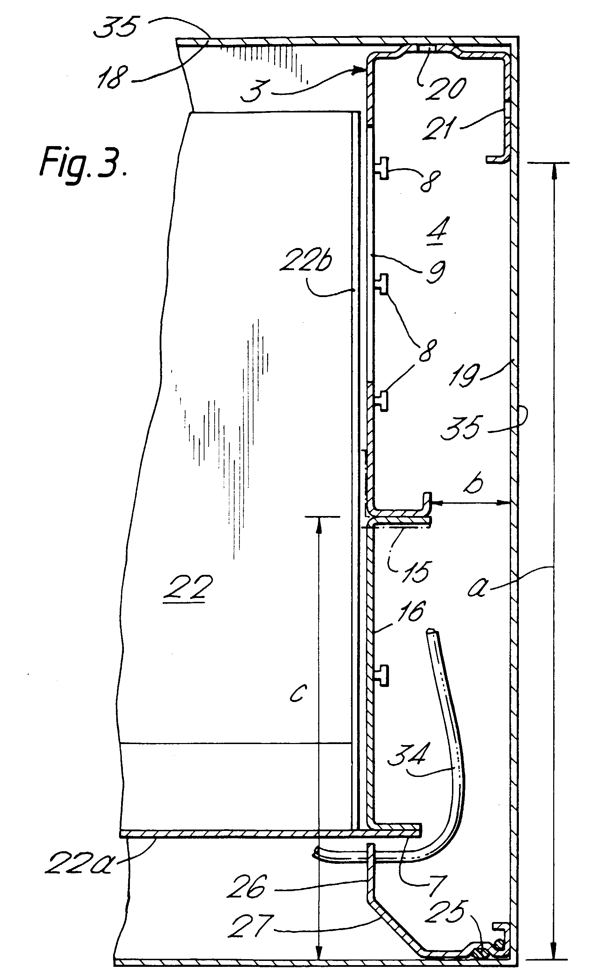

In order to mount the card-frame, it may be provided with a flange 15 about half way along its side for bolting directly to the front of the structural member, or an adaptor 16 may be used to connect the structural member to a flange 7 in its conventional position at the front of the card-frame as shown in Figure 3. These adaptors are relatively short in a vertical direction, and may if desired be permanently affixed to the structural members, e.g. by welding.

If desired, a slightly flexible sheet metal door (not shown) with a hinge edge stiffener and pivot pins may be mounted, by springing it into engagement with holes provided in a base and top of the rack.

If it is preferred to use the rack without doors covering the fronts of the card-frames, it may be thought desirable for the sake of appearance or in some cases for protection to use these hinge-pin apertures instead to mount trim strips 25 (Figures 2 and 3) forming covers for the fronts of the cabling spaces. If (in such a case) cables 34 pass from the cabling spaces around the front of any of the card-frames, as seen at 26, some appropriate provision will be needed to allow them to pass through the trim strips; here this provision is illustrated by a brush edge to the steel cable cover 27 on which trim strip 25 is provided.

Rear panels 18 and side panels 19 can be mounted to the racks of the invention in an entirely conventional manner.

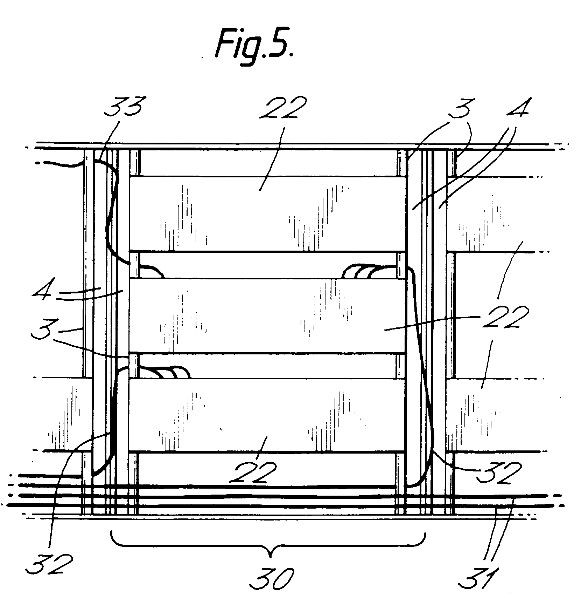

Racks embodying the invention may be cabled in many different ways; Figure 5 shows an extremely facile way: the rack 30 is seen in position between other identical racks in a row and with any doors and trim strips removed, but with the card-frames 22 and their boards already in position. There may be existing cabling (not shown) in position and in service also. Cables 31 are rolled into place in the usual way along the bottom of the row of racks; cables 32 are similarly rolled into place until they reach this rack and are then simply rolled into the cabling spaces to the left or right of it, as convenient, and then across the front of the adjacent structural member 3 to be terminated within one of the card-frames 22. Cable 33, interconnecting equipment in adjacent racks, is similarly just tucked into the left-hand cabling space and taken across the fronts of two structural members for termination. In all cases the cables can be secured by tying to the extent found necessary.

## Claims

1. A rack for electronic equipment based on modules of predetermined size, the rack comprising a pair of vertical structural members (3) positioned on respective sides of the rack to receive and support card-frames (22) of predetermined dimensions in a vertical array between them and to support cables (34) to be connected to electronic equipment to be mounted in one or more of the said card-frames (22), wherein each structural member (3) comprises a vertically extending central portion (6), a rear flanged portion (5a) extending outwardly from the central portion (6) to the respective side of the rack and then forwardly towards the front of the rack, and a front flanged portion (5b) extending outwardly from the central portion (6) to the side of the rack, the rear flanged portion (5a) extending outwardly further than the front flanged portion (5b), and wherein the said structural members (3) define at respective sides of the rack vertically extending cabling spaces (4) which are open and free of fixed obstructions over at least a major part, or major parts, of the height of the cabling spaces (4)
(a) outwardly to respective sides of the rack over at least a major part of the depth from front to back of the rack;
(b) towards the front of the rack adjacent to its side; and
(c) inwardly towards the card-frame mounting space over at least a major part, or major parts, of the height of the rack.

2. A rack as claimed in claim 1 in which the said openings to the side and the front are free of all fixed obstructions from top to bottom of the rack.

3. A rack as claimed in claim 1 or claim 2 in which tabs (8) or other formations are provided on the sides of the structural members (3) that face the cabling spaces (4) in order to provide anchorages for ties or other securing means for cables (34).

4. A rack as claimed in any one of claims 1 to 3 in which removable trim members (29) enclose the front of each cabling space (4).

5. A rack as claimed in claim 4 in which the said trim members (29) are provided with brush edges, flexible edges, openings or knock-outs to permit passage of cables (34) around the front edges of card-frames (22).

## Patentansprüche

1. Gestell für elektronische Ausrüstung auf der Basis von Elementen vorbestimmter Größe, wobei das Gestell ein Paar vertikaler Bauteile (3) umfaßt, die auf jeweiligen Seiten des Gestelles positioniert sind, um Platinenrahmen (22) vorbestimmter Abmessungen in einer vertikalen Anordnung zwischen ihnen und Tragkabeln (34) aufzunehmen und zu unterstützen, um mit elektronischer Ausrüstung verbunden zu werden, die an einem oder mehreren der Platinenrahmen (22) befestigt werden soll, wobei jedes Bauteil (3) einen vertikal sich erstreckenden mittigen Abschnitt (6), einen hinteren mit Flansch versehenen Abschnitt (5a), der sich von dem mittigen Abschnitt (6) nach außen zu der betreffenden Seite des Gestelles und dann nach vorne zu der Vorderseite des Gestelles erstreckt, und einen vorderen mit Flansch versehenen Abschnitt (5b), der sich nach außen von dem mittigen Abschnitt (6) zu der Seite des Gestelles erstreckt, umfaßt, der hintere mit Flansch versehene Abschnitt (5a) sich weiter nach außen als der vordere mit Flansch versehene Abschnitt (5b) erstreckt und die Bauteile (3) an jeweiligen Seiten des Gestelles vertikal sich erstreckende Verkabelungsräume (4) begrenzen, welche über wenigstens einen größeren Teil oder größere Teile der Höhe der Verkabelungsräume (4)
(a) auswärts zu den jeweiligen Seiten des Gestelles über wenigstens einen Hauptteil der Tiefe von der Vorderseite zu der Rückseite des Gestelles,
(b) zu der Vorderseite des Gestelles in Nachbarschaft zu seiner Seite und
(c) nach innen zu dem Platinenrahmenbefestigungsraum über wenigstens einen größeren Teil oder größere Teile der Höhe des Gestelles offen und frei von ortsfesten Hindernissen sind.

2. Gestell nach Anspruch 1, bei welchem die Öffnungen zu der Seite und der Vorderfront vom oberen Ende zum unteren Ende des Gestelles frei von allen ortsfesten Hindernissen sind.

3. Gestell nach Anspruch 1 oder Anspruch 2, bei welchem Ansätze (8) oder andere Gebilde an den Seiten der Bauteile (3) vorgesehen sind, die zu den Verkabelungsräumen (4) hinblicken, um Verankerungen für Bänder oder andere Befestigungseinrichtungen für Kabel (34) zu bekommen.

4. Gestell nach einem der Ansprüche 1 bis 3, in welchem entfernbare Einfassungsteile (29) die Vorderfront jedes Verkabelungsraumes (4) einschließen.

5. Gestell nach Anspruch 4, in welchem die Einfassungsteile (29) mit Bürstenkanten, flexiblen Kanten, Öffnungen oder Ausstoßeinrichtungen versehen sind, um einen Durchgang von Kabeln (34) um die Vorderkanten von Platinenrahmen (22) zu erlauben.

## Revendications

1. Bâti pour matériel électronique basé sur des modules de taille prédéterminée, le bâti comprenant deux éléments structurels verticaux (3), placés des côtés respectifs du bâti, pour recevoir et supporter, entre eux, des paniers à cartes (22) de dimensions prédéterminées, en une rangée verticale, et pour supporter des câbles (34) à connecter au matériel électronique devant être monté dans un, ou plusieurs, desdits paniers à cartes (22), dans lequel chaque élément structurel (3) comprend une partie centrale s'étendant verticalement (6), une partie arrière à rebord (5a) s'étendant vers l'extérieur de la partie centrale (6) vers le côté respectif du bâti et ensuite vers l'avant en direction de l'avant du bâti, et une partie avant à rebord (5b) s'étendant vers l'extérieur de la partie centrale (6) vers le côté du bâti, la partie arrière à rebord (5a) s'étendant plus vers l'extérieur que la partie avant à rebord (5b), et dans lequel lesdits éléments structurels (3) définissent, au niveau des côtés respectifs du bâti, des espaces de câblage (4) s'étendant verticalement qui sont ouverts et exempts d'obstacles fixes sur au moins une majeure partie, ou des majeures parties, de la hauteur des espaces de câblage (4) ;
(a) vers l'extérieur des côtés respectifs du bâti, sur au moins une majeure partie de la profondeur d'avant en arrière du bâti ;
(b) vers l'avant du bâti, adjacent à ses côtés ; et
(c) vers l'intérieur en direction de l'espace de montage de panier à cartes, sur au moins une majeure partie, ou des majeures parties, de la hauteur du bâti.

2. Bâti selon la revendication 1, dans lequel lesdites ouvertures situées sur le côté et l'avant sont exemptes de tous obstacles fixes, de haut en bas du bâti.

3. Bâti selon la revendication 1 ou la revendication 2, dans lequel des pattes (8), ou autres conformations, sont réalisées sur les côtés des éléments structurels (3) qui font face aux espaces de câblage (4) afin de fournir des points d'ancrage pour des attaches ou autres moyens de fixation de câbles (34).

4. Bâti selon l'une quelconque des revendications 1 à 3, dans lequel des éléments de garnissage amovibles (29) renferment l'avant de chaque espace de câblage (4).

5. Bâti selon la revendication 4, dans lequel lesdits éléments de garnissage (29) sont munis de bords en brosse, de bords souples, d'ouvertures, ou de découpes, pour permettre le passage de câbles (34) autour des bords avant des paniers à cartes (22).
